# FASCICULE DE BREVET EUROPEEN

(11) **EP 2 518 818 B1**
(45) Date de publication et mention de la délivrance du brevet: **20.04.2016**
(21) Numéro de dépôt: 12165254.9
(22) Date de dépôt: 24.04.2012
(51) Int. Cl.: H01M 2/20, H01M 10/42, H01M 10/615, H01M 10/6571, H01M 10/667, H05K 1/02

(54) **Dispositif de connexion électrique**
Elektrische Verbindungsvorrichtung
Electrical connection device

(30) Priorité: 26.04.2011 FR 1153568
(43) Date de publication de la demande: 31.10.2012
(73) Titulaire: SAFT, 93170 Bagnolet (FR)
(72) Inventeur: Rabaud, Olivier, 33300 Bordeaux (FR); Narbonne, Alexandre, 33290 Blanquefort (FR)
(74) Mandataire: Hirsch & Associés

(56) Documents cités:
- DE-A1-102008 005 891
- DE-U1- 8 814 571
- JP-A- 2002 260 745
- US-A1- 2005 264 257
- US-A1- 2010 330 403

## Description

L'invention concerne un dispositif de connexion électrique entre des générateurs électrochimiques dans une batterie. Plus particulièrement l'invention concerne l'intégration d'un dispositif de réchauffement des générateurs électrochimiques au dispositif de connexion de puissance. L'invention concerne également une batterie comprenant un tel dispositif de connexion ainsi qu'un procédé de fabrication de ce dispositif de connexion.

Typiquement une batterie comporte une pluralité de générateurs électrochimiques appelés aussi accumulateurs, cellules ou éléments. Les générateurs électrochimiques sont reliés entre eux en série et/ou en parallèle par des dispositifs de connexion électrique formant des pistes de puissance. Un dispositif connu de connexion électrique entre générateurs électrochimiques est décrit dans le document JP-A-2007323951. Chaque générateur électrochimique se décharge en fournissant de l'énergie électrique à une application donnée. La batterie peut être chargée par un chargeur qui fournit de l'énergie électrique aux bornes de la batterie pour augmenter la quantité d'énergie électrique stockée dans chaque générateur électrochimique. Il est également connu de prévoir un circuit électronique de contrôle et de gestion des générateurs électrochimiques pour contrôler leur état de charge et/ou leur état de santé, notamment au moyen de mesures de tension ou de courant individuelles ou de mesures au niveau d'un groupe de générateurs électrochimiques.

Les contraintes de contrôle électronique des générateurs peuvent être prises en charge par un circuit imprimé (désigné PCB pour « Printed Circuit Board » on anglais) qui comporte des composants électroniques permettant un contrôle des paramètres des générateurs électrochimiques, tels que des composants de mesure du courant ou de la tension, des capteurs de température, ou autres. Le courant pour les mesures de contrôle et/ou de gestion des générateurs électrochimiques est conduit au moyen de pistes gravées sur le circuit imprimé.

Les contraintes de connexion électrique entre générateurs peuvent être prises en charge par un ensemble mécanique appelé "busbar". Un busbar se compose typiquement de barrettes ou de pistes gravées sur PCB, très souvent en cuivre assurant la connexion de puissance entre les bornes des générateurs. Un tel busbar permet d'intégrer l'électronique de contrôle avec la connexion de puissance, et permet de positionner en une fois l'ensemble des barrettes de connexion sur la pluralité de générateurs électrochimiques.

On connaît par ailleurs des systèmes dits SMI (Substrat Métallique Isolé). Un tel système comprend un circuit imprimé rigide ou flexible auquel est fixée une semelle métallique, généralement de l'aluminium. Le circuit imprimé et la semelle métallique sont assemblés au moyen d'une colle thermoconductrice. Le circuit imprimé comprend des composants électroniques montés en surface et la semelle métallique assure la dissipation thermique pour le refroidissement des composants montés sur le circuit imprimé.

Pour certaines applications, les générateurs doivent être maintenus dans une gamme de température donnée pour que la charge soit autorisée ; c'est notamment le cas des générateurs Li-ion. Or, dans certaines applications, comme des relais télécom par exemple, les températures d'utilisation peuvent descendre jusqu'à -40°C ; les générateurs doivent alors être réchauffés pour autoriser la charge ou la décharge.

On utilise typiquement des réchauffeurs constitués de couvertures chauffantes placées au contact ou à proximité des générateurs, comme décrit dans le document US-A-2008/0226969, ou constitués d'un circuit de circulation de fluides chauds, comme décrit dans les documents EP-A-0 624 916 ou EP-A-0 964 460.

Ces réchauffeurs sont complexes car leur efficacité dépend fortement du bon contact avec les générateurs : en cas de mauvais contact, il y a un risque de surchauffe et de dégradation des composants de la batterie. La conception de la batterie doit être adaptée pour intégrer efficacement des réchauffeurs (composants supplémentaires d'assemblage, contraintes d'isolement, gestion de l'étanchéité lorsque des fluides chauds sont utilisés...).

Le document JP-A-2002-260745 propose de placer une résistance sur les barrettes de connexion de puissance reliant les bornes des générateurs. Les circuits de puissance et de contrôle sont totalement dissociés ; les résistances sont donc alimentées par le courant circulant entre les bornes des générateurs. Ainsi, lorsque l'environnement est à une température inférieure à -20°C et que la batterie est déchargée, le réchauffement ne peut être assuré.

Le document US-A-2009/0162738 propose de placer une pièce chauffante en céramique sur une borne du générateur pour réchauffer le faisceau électrochimique. La pièce céramique est chauffée par un courant provenant de la batterie elle-même. Ainsi, lorsque l'environnement est à une température inférieure à -20°C et que la batterie est déchargée, le réchauffement ne peut être assuré.

Le document FR-A-2 787 242 propose de placer une résistance à l'intérieure de la batterie pour réchauffer la solution d'électrolyte ; cette résistance est alimentée aux bornes de la batterie. Ainsi, lorsque l'environnement est à une température inférieure à -20°C et que la batterie est déchargée, le réchauffement ne peut être assuré.

Il existe un besoin pour un système de réchauffement de générateurs électrochimiques qui soit simple à mettre en oeuvre et efficace quelles que soient les conditions environnementales.

A cet effet, l'invention propose d'exploiter la chaleur dissipée par des éléments du circuit électronique associé à la batterie et de conduire cette chaleur dissipée vers les bornes des générateurs.

Plus spécifiquement, l'invention propose un dispositif de connexion électrique pour batterie comprenant :
- un circuit électronique comprenant au moins un élément présentant des pertes thermiques ;
- au moins une piste de puissance adaptée à relier des bornes d'au moins deux générateurs électrochimiques ;
- au moins une liaison thermiquement conductrice adaptée à relier ledit au moins un élément présentant des pertes thermiques et au moins une des bornes d'un des générateurs le circuit électronique et ladite au moins une piste de puissance étant agencés sur une carte électronique, caractérisé en ce que le dispositif comprend des pistes d'alimentation électrique (7) dudit au moins un élément (6) présentant des pertes thermiques, lesdites. pistes d'alimentation électrique (7) étant électriquement isolées des pistes de puissance (5) reliant les bornes (4) des générateurs électrochimiques (3).

Selon les modes de réalisation, le dispositif selon l'invention présente une ou plusieurs de caractéristiques suivantes :
- ledit au moins un élément présentant des pertes thermiques est choisi parmi une résistance, une inductance, une diode, un transistor, un fusible, une restriction de section d'une piste de connexion électrique ;
- ledit au moins un élément présentant des pertes thermiques est positionné à une distance inférieure à 50 mm de la borne d'un générateur électrochimique ;
- la liaison thermiquement conductrice inclut au moins une portion d'une connexion de puissance ;
- ledit au moins un élément présentant des pertes thermiques comprend une semelle métallique soudée directement sur ladite au moins une piste de puissance.

L'invention concerne aussi une batterie comprenant une pluralité de générateurs électrochimiques et au moins un dispositif de connexion électrique selon l'invention.

Selon les modes de mise en oeuvre, la batterie selon l'invention comprend un élément présentant des pertes thermiques par piste de puissance reliant les bornes de deux générateurs électrochimiques, ou un élément présentant des pertes thermiques par générateur électrochimique, ou une pluralité d'éléments présentant des pertes thermiques par piste de puissance reliant les bornes de deux générateurs électrochimiques.

Selon un mode de réalisation, la batterie comprend en outre un microcontrôleur adapté à commander l'alimentation électrique des éléments présentant des pertes thermiques.

Selon un mode de réalisation, la batterie est reliée à une alimentation électrique extérieure assurant la charge, dans laquelle le microcontrôleur commande l'alimentation électrique des éléments présentant des pertes thermiques par l'alimentation extérieure.

L'invention concerne en outre un procédé de fabrication d'un dispositif de connexion électrique pour batterie comprenant les étapes consistant à :
- établir des connexions de puissance entre des bornes d'un moins deux générateurs électrochimiques ;
- fournir au moins un élément présentant des pertes thermiques ;
- établir une liaison thermiquement conductrice, sans que soit établie une liaison électrique, entre ledit au moins un élément présentant des pertes thermiques et au moins une des bornes d'un des générateurs, le circuit électronique et au moins une connexion de puissance étant agencés sur une carte électronique, caractérisé en ce que qu'on alimente électriquement par des pistes d'alimentation électrique (7) ledit au moins un élément (6) présentant des pertes thermiques, lesdites pistes d'alimentation électrique (7) étant électriquement isolées des pistes de puissance (5) reliant les bornes (4) des générateurs électrochimiques (3).

Selon un mode de réalisation, la liaison thermiquement conductrice est établie en incluant au moins une portion d'une connexion de puissance.

D'autres caractéristiques et avantages de l'invention apparaîtront à la lecture de la description détaillée qui suit. Cette description est donnée à titre d'exemple uniquement, et en référence aux figures annexées qui montrent :
- figure 1, un schéma d'un dispositif de connexion selon l'invention ;
- figure 2, un schéma électrique d'un dispositif de connexion selon l'invention ;
- figure 3, un schéma d'un module de batterie auquel un dispositif de connexion selon l'invention est appliqué dans un exemple de mise en oeuvre ;
- figure 4, un schéma de l'implantation des résistances dans le dispositif de connexion selon l'invention appliqué au module de la figure 3 ;
- figure 5, un graphe de l'évolution dans le temps des températures au centre de certains générateurs dans l'exemple de mise en oeuvre de la figure 3 ;
- figure 6, un graphe de l'évolution dans le temps des températures des résistances dans l'exemple de mise en oeuvre de la figure 4.

L'invention concerne un dispositif de connexion électrique pour batterie composé d'une partie de mesure et de contrôle - circuit électronique - et d'une partie de puissance. Selon l'invention, le ou les éléments du circuit électronique qui présentent des pertes thermiques sont thermiquement reliés aux pistes de puissance qui relient les bornes des générateurs électrochimiques.

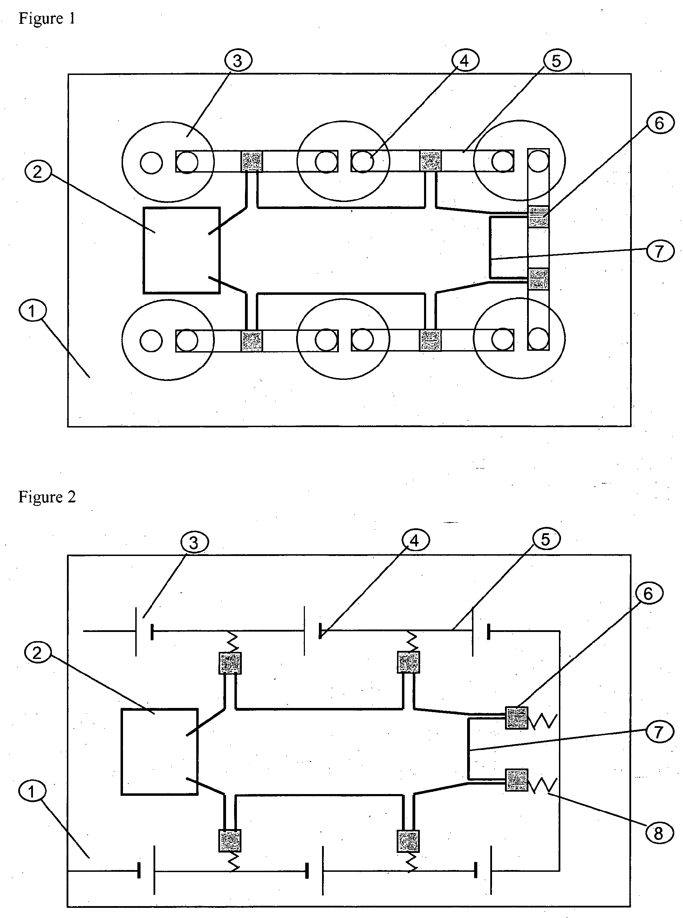

La structure du dispositif selon l'invention va être décrite en se référant à la figure 1. Sur le schéma de la figure 1, les dimensions des différents éléments ne sont pas respectées.

La figure 1 montre un dispositif de connexion électrique comprenant une carte électronique 1 de type carte de circuit imprimé ou PCB. Une telle carte peut être composée matériau semi-rigide retardateur de flamme tel que du FR4 (Flame Resistant 4). L'épaisseur de la carte de circuit imprimé 1 peut-être comprise entre 0,05 mm et 3,2 mm selon le matériau choisi.

La figure 1 montre aussi une pluralité de générateurs électrochimiques 3 présentant des bornes 4 de sortie de courant et reliés en série par des pistes de puissance 5. Les pistes de puissance 5 peuvent être des pistes de cuivre gravées sur la carte électronique 1.

La carte de circuit imprimé 1 constitue un support pour un circuit électronique 2 d'une part et pour les piste de puissance 5 d'autre part. Le circuit électronique 2 comprend des composants électroniques, tels que des composants de mesure, des sondes de température, des faisceaux de signal, des bornes, des fusibles, des contacteurs, des microcontrôleurs, de l'électronique de traitement du signal, ou autres, ainsi que des pistes de connexion électrique. Parmi l'ensemble des éléments du circuit électronique 2, certains éléments 6 présentent des pertes thermiques, tels que des résistances, des inductances, des composants à semi-conducteur tels que diodes ou transistors, des restrictions de section d'une piste de connexion électrique, des fusibles ou autres. La chaleur dissipée par ces éléments 6 présentant des pertes thermiques est exploitée pour réchauffer les générateurs électrochimiques 3 à travers leurs bornes 4 de sortie de courant.

La figure 1 montre aussi des pistes d'alimentation électrique 7, en cuivre par exemple, qui permettent de délivrer du courant électriques aux éléments 6. Ces pistes d'alimentation électrique 7 sont totalement distinctes et électriquement isolées des pistes de puissance 5 reliant les bornes 4 des générateurs électrochimiques. L'alimentation des éléments 6 présentant des pertes thermiques ne se fait pas par les bornes 4 des générateurs électrochimiques 3 mais par une alimentation extérieure contrôlée par un microcontrôleur du circuit électronique 2.

La figure 2 illustre la structure électrique du dispositif selon l'invention. Les mêmes numéros de référence sont utilisés pour désigner les mêmes éléments que ceux décrits en référence à la figure 1. La figure 2 montre un pontage thermique 8 qui est établi entre les éléments 6 présentant des pertes thermiques et les bornes 4 des générateurs 3.

Les éléments 6 présentant des pertes thermiques sont positionnés à proximité des bornes 4 des générateurs électrochimiques 3 afin de permettre un pontage thermique efficace entre ces éléments 6 et les bornes 4 des générateurs. En effet, les pertes thermiques des éléments 6 du circuit électronique 2, au lieu d'être dissipées dans l'atmosphère comme c'est généralement le cas dans les dispositifs de l'art antérieur, sont exploitées pour réchauffer à coeur les générateurs électrochimiques 3. On évite ainsi l'utilisation de couvertures chauffantes et/ou de circuits de circulation de fluides chauds. La batterie intégrant un dispositif de connexion selon l'invention est donc simplifiée tout en permettant une utilisation dans des conditions de grand froid.

Le demandeur a observé qu'une distance inférieure à 50 mm entre les éléments 6 présentant des pertes thermiques et les bornes 4 des générateurs électrochimiques 3 était appropriée. Le pontage thermique 8 peut être assuré par une piste métallique, en cuivre par exemple, agencée entre l'élément 6 présentant des pertes thermiques et la piste de puissance 5 ou directement entre le l'élément 6 présentant des pertes thermiques et la borne 4 de sortie d'un générateur 3. Lorsque l'élément 6 présentant des pertes thermiques est un composant électronique, le pontage thermique 8 peut aussi être assuré par soudure de la semelle métallique du composant 6 présentant des pertes thermiques directement sur la piste de puissance 5. Dans ce cas, contrairement aux réchauffeurs de l'art antérieur, cette solution offre une facilité de montage parce qu'elle est intégrée dans le procédé de fabrication de la carte électronique.

Selon les applications envisagées, on peut prévoir un élément 6 présentant des pertes thermiques par générateur électrochimique de la batterie ou un élément 6 présentant des pertes thermiques par piste de puissance 5, c'est-à-dire un élément 6 présentant des pertes thermiques pour deux générateurs. On peut aussi prévoir, sur une même piste de puissance, deux éléments 6 présentant des pertes thermiques afin de réchauffer différemment chaque générateur relié à cette piste.

Comme indiqué plus haut, les éléments 6 présentant des pertes thermiques sont alimentés électriquement par des pistes d'alimentation électrique 7 totalement distinctes et électriquement isolées des pistes de puissance 5. On peut ainsi prévoir que l'alimentation électrique des éléments 6 présentant des pertes thermiques est assurée par une alimentation extérieure à laquelle est reliée la batterie, notamment l'alimentation extérieure assurant la charge de la batterie - réseau ou alimentation en énergie renouvelable ou supercondensateur ou autre. Le réchauffement à coeur des générateurs électrochimiques ne dépend pas des générateurs eux même.

On peut par exemple envisager le mode de fonctionnement suivant :
Lorsque la batterie est en attente de sollicitation par l'application extérieure, et maintenu à tension constante (désigné par l'expression « floating state » en anglais) et que l'alimentation extérieure est disponible, le microcontrôleur commande l'alimentation électrique des éléments 6 présentant des pertes thermiques dès que la température descend en dessous de 0°C. En cas de coupure de l'alimentation extérieure, les générateurs de la batterie seront à une température supérieure à 0°C pour une autoriser une décharge dans de bonnes conditions et garantir l'alimentation électrique de l'application.

Lorsque l'alimentation extérieure est à nouveau disponible, la décharge est arrêtée ; mais si la température de la batterie est devenue inférieure à -20°C, la recharge n'est pas autorisée. Il convient alors de réchauffer les générateurs avant d'autoriser la recharge. Les éléments 6 présentant des pertes thermiques sont alors alimentés jusqu'à ramener la température des générateurs 3 à -20°C et permettre un premier palier de recharge. On comprend dans ces circonstances que le réchauffement ne doit pas dépendre de la disponibilité en courant des générateurs eux-mêmes et que le réchauffement doit être rapide et efficace afin de disposer d'une batterie rechargée en cas de nouvelle coupure de l'alimentation extérieure.

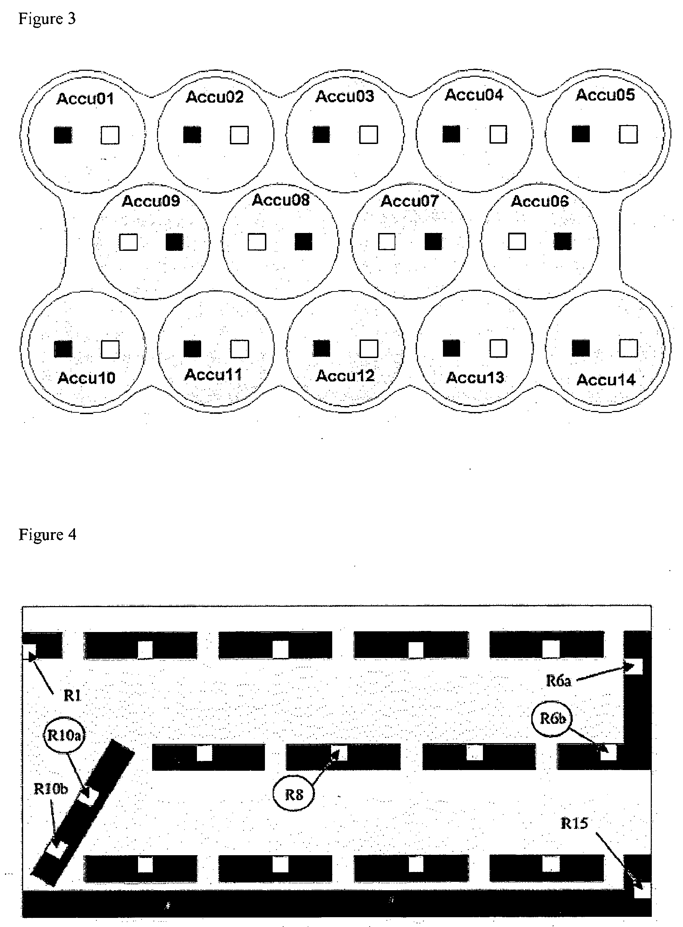

Le demandeur a conduit plusieurs essais avec des dispositifs de connexion selon l'invention. Les essais ont été conduits avec une batterie comprenant 14 générateurs électrochimique de type Li-ion. La température d'origine est de -40°C. La configuration des éléments présentant des pertes thermiques - disposition et puissance - pour ramener les générateurs à une température de -20°C en un délai donné a été étudiée. Des résistances ont été utilisées comme éléments présentant des pertes thermiques pour les essais reproduits ci-dessous. Le schéma de la figure 3 montre le positionnement des générateurs dans le module de batterie utilisé pour les essais et la figure 4 montre une implantation retenue de résistances sur la carte électronique.

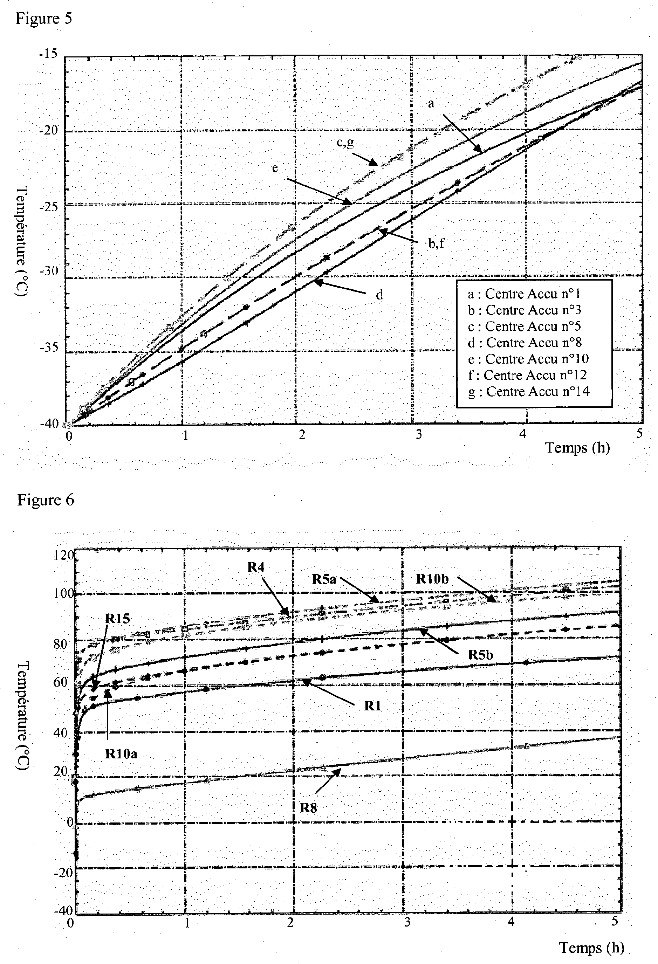

Le graphe de la figure 5 montre l'évolution dans le temps des températures au centre des générateurs n°1, n°3, n°5, n°8, n°10, n°12 et n°14 (en référence à la figure 3) et la figure 6 montre l'évolution dans le temps des températures des résistance R1, R4, R5a, R5b, R8, R10a, R10b et R15 (en référence à la figure 4).

La disposition et la puissance des résistances ont été choisies pour atténuer les points chauds au centre et les coins plus froids et limiter les gradients thermiques entre les résistances et les bornes des générateurs. La puissance des résistances de coin (RI, R6a, R10b et R15 sur la figure 4) est augmentée par rapport à celle des résistances de centre (R6b, R8 et R10a sur la figure 4). Les résistances ont été soudées directement sur les barrettes de puissance reliant deux générateurs en série. Des résistances de 10x10 mm² de puissance 1,7W pour les résistances au centre et 3,9W pour les résistances de coin ont été utilisées.

Comme illustré sur la figure 5, le temps pour réchauffer l'ensemble des générateurs de -40°C à -20°C est de 4h30 environ. Le gradient thermique entre les générateurs est inférieur à 5°C. Les résistances ne dépassent pas 105°C après 5h de chauffe (figure 6).

Il est bien entendu que d'autres types d'éléments présentant des pertes thermiques peuvent être utilisés et que la disposition et les puissances appliquées peuvent être ajustées selon les applications envisagées.

Le dispositif de connexion électrique selon l'invention peut être fabriqué comme suit. Pour un module de batterie donné, présentant un nombre et un agencement connus de générateurs électrochimique, une carte électronique est conçue comprenant des connexions de puissance 5 pour relier les bornes 4 des générateurs électrochimiques 3. Au moins un élément 6 présentant des pertes thermiques est positionné sur la carte. En pratique, le nombre et la disposition des éléments 6 présentant des pertes thermiques sera déterminé en fonction du nombre et de la disposition des générateurs électrochimique de la batterie à équiper. Des ponts thermiques 8 sont alors établis, sans que soit établie de liaison électrique, entre les éléments 6 présentant des pertes thermiques les bornes 4 des générateurs.

Le dispositif de connexion selon l'invention peut donc être adapté à tout type de batterie quel que soit le nombre et la disposition des générateurs électrochimiques.

## Revendications

1. Dispositif de connexion électrique pour batterie comprenant :
- un circuit électronique (2) comprenant au moins un élément (6) présentant des pertes thermiques ;
- au moins une piste de puissance (5) adaptée à relier des bornes (4) d'au moins deux générateurs électrochimiques (3) ;
- au moins une liaison thermiquement conductrice (8) adaptée à relier ledit au moins un élément (6) présentant des pertes thermiques et au moins une des bornes (4) d'un des générateurs (3), le circuit électronique et ladite au moins une piste de puissance étant agencés sur une carte électronique, **caractérisé en ce que** le dispositif comprend des pistes d'alimentation électrique (7) dudit au moins un élément (6) présentant des pertes thermiques, lesdites pistes d'alimentation électrique (7) étant électriquement isolées des pistes de puissance (5) reliant les bornes (4) des générateurs électrochimiques (3).

2. Dispositif selon la revendication 1, dans lequel ledit au moins un élément (6) présentant des pertes thermiques est choisi parmi une résistance, une inductance, une diode, un transistor, un fusible, une restriction de section d'une piste de connexion électrique.

3. Dispositif selon l'une des revendications précédentes, dans lequel ledit au moins un élément (6) présentant des pertes thermiques est positionné à une distance inférieure à 50 mm de la borne (4) d'un générateur électrochimique (3).

4. Dispositif selon l'une des revendications précédentes, dans lequel la liaison thermiquement conductrice (8) inclut au moins une portion d'une connexion de puissance (5).

5. Dispositif selon la revendication 4, dans lequel ledit au moins un élément (6) présentant des pertes thermiques comprend une semelle métallique soudée directement sur ladite au moins une piste de puissance (5).

6. Batterie comprenant une pluralité de générateurs électrochimiques (3) et au moins un dispositif de connexion électrique selon l'une des revendications 1 à 5.

7. Batterie selon la revendication 6, comprenant un élément (6) présentant des pertes thermiques par piste de puissance (5) reliant les bornes (4) de deux générateurs électrochimiques (3).

8. Batterie selon la revendication 6, comprenant un élément (6) présentant des pertes thermiques par générateur électrochimique (3).

9. Batterie selon la revendication 6, comprenant une pluralité d'éléments (6) présentant des pertes thermiques par piste de puissance (5) reliant les bornes (4) de deux générateurs électrochimiques (3).

10. Batterie selon l'une des revendications 6 à 9, comprenant en outre un microcontrôleur adapté à commander l'alimentation électrique des éléments (6) présentant des pertes thermiques.

11. Batterie selon la revendication 10, reliée à une alimentation électrique extérieure assurant la charge, dans laquelle le microcontrôleur commande l'alimentation électrique des éléments (6) présentant des pertes thermiques par l'alimentation extérieure.

12. Procédé de fabrication d'un dispositif de connexion électrique pour batterie comprenant les étapes consistant à :
- établir des connexions de puissance (5) entre des bornes (4) d'un moins deux générateurs électrochimiques (3) ;
- fournir un circuit électronique (2) comprenant au moins un élément (6) présentant des pertes thermiques ;
- établir une liaison thermiquement conductrice (8), sans que soit établie une liaison électrique, entre ledit au moins un élément (6) présentant des pertes thermiques et au moins une des bornes (4) d'un des générateurs (3) ;
le circuit électronique et au moins une connexion de puissance étant agencés sur une carte électronique, **caractérisé en ce qu'**on alimente électriquement par des pistes d'alimentation électrique (7) ledit au moins un élément (6) présentant des pertes thermiques, lesdites pistes d'alimentation électrique (7) étant électriquement isolées des pistes de puissance (5) reliant les bornes (4) des générateurs électrochimiques (3).

13. Procédé de la revendication 12, dans lequel la liaison thermiquement conductrice (8) est établie en incluant au moins une portion d'une connexion de puissance (5).

## Patentansprüche

1. Elektrische Verbindungsvorrichtung für eine Batterie, umfassend:
- eine elektronische Schaltung (2), die wenigstens ein Element (6) umfasst, das Wärmeverluste aufweist;
- wenigstens einen Leistungspfad (5), der dafür eingerichtet ist, Klemmen (4) von wenigstens zwei elektrochemischen Generatoren (3) zu verbinden;
- wenigstens eine wärmeleitende Verbindung (8), die dafür eingerichtet ist, das wenigstens eine Element (6), das Wärmeverluste aufweist, und wenigstens eine der Klemmen (4) eines der Generatoren (3) zu verbinden, wobei die elektronische Schaltung und der wenigstens eine Leistungspfad auf einer Leiterplatte angeordnet sind,
**dadurch gekennzeichnet, dass** die Vorrichtung Pfade zur Stromversorgung (7) des wenigstens einen Elements (6), das Wärmeverluste aufweist, umfasst, wobei die Pfade zur Stromversorgung (7) von den Leistungspfaden (5), welche die Klemmen (4) der elektrochemischen Generatoren (3) verbinden, elektrisch isoliert sind.

2. Vorrichtung nach Anspruch 1, wobei das wenigstens eine Element (6), das Wärmeverluste aufweist, aus einem Widerstand, einer Drossel, einer Diode, einem Transistor, einer Schmelzsicherung und einer Querschnittsverengung eines elektrischen Verbindungspfades ausgewählt ist.

3. Vorrichtung nach einem der vorhergehenden Ansprüche, wobei das wenigstens eine Element (6), das Wärmeverluste aufweist, in einem Abstand von weniger als 50 mm von der Klemme (4) eines elektrochemischen Generators (3) positioniert ist.

4. Vorrichtung nach einem der vorhergehenden Ansprüche, wobei die wärmeleitende Verbindung (8) wenigstens einen Abschnitt einer Leistungsverbindung (5) beinhaltet.

5. Vorrichtung nach Anspruch 4, wobei das wenigstens eine Element (6), das Wärmeverluste aufweist, eine metallische Sohle umfasst, die direkt auf den wenigstens einen Leistungspfad (5) geschweißt ist.

6. Batterie, welche mehrere elektrochemische Generatoren (3) und wenigstens eine elektrische Verbindungs-vorrichtung nach einem der Ansprüche 1 bis 5 umfasst.

7. Batterie nach Anspruch 6, welche ein Element (6), das Wärmeverluste aufweist, pro Leistungspfad (5), der die Klemmen (4) von zwei elektrochemischen Generatoren (3) verbindet, umfasst.

8. Batterie nach Anspruch 6, welche ein Element (6), das Wärmeverluste aufweist, pro elektrochemischen Generator (3) umfasst.

9. Batterie nach Anspruch 6, welche mehrere Elemente (6), die Wärmeverluste aufweisen, pro Leistungspfad (5), der die Klemmen (4) von zwei elektrochemischen Generatoren (3) verbindet, umfasst.

10. Batterie nach einem der Ansprüche 6 bis 9, welche außerdem einen Mikrocontroller umfasst, der dafür eingerichtet ist, die Stromversorgung der Elemente (6), die Wärmeverluste aufweisen, zu steuern.

11. Batterie nach Anspruch 10, die mit einer externen Stromversorgung verbunden ist, welche das Laden sicherstellt, wobei der Mikrocontroller die Stromversorgung der Elemente (6), die Wärmeverluste aufweisen, durch die externe Stromversorgung steuert.

12. Verfahren zur Herstellung einer elektrischen Verbindungsvorrichtung für eine Batterie, welches die folgenden Schritte umfasst:
- Herstellen von Leistungsverbindungen (5) zwischen Klemmen (4) von wenigstens zwei elektrochemischen Generatoren (3);
- Bereitstellen einer elektronischen Schaltung (2), die wenigstens ein Element (6) umfasst, das Wärmeverluste aufweist;
- Herstellen einer wärmeleitenden Verbindung (8), ohne dass eine elektrische Verbindung hergestellt wird, zwischen dem wenigstens einen Element (6), das Wärmeverluste aufweist, und wenigstens einer der Klemmen (4) eines der Generatoren (3);
wobei die elektronische Schaltung und wenigstens eine Leistungsverbindung auf einer Leiterplatte angeordnet sind, **dadurch gekennzeichnet, dass** das wenigstens eine Element (6), das Wärmeverluste aufweist, durch Pfade zur Stromversorgung (7) mit Strom versorgt wird, wobei die Pfade zur Stromversorgung (7) von den Leistungspfaden (5), welche die Klemmen (4) der elektrochemischen Generatoren (3) verbinden, elektrisch isoliert sind.

13. Vorrichtung nach Anspruch 12, wobei die wärmeleitende Verbindung (8) hergestellt wird, indem wenigstens ein Abschnitt einer Leistungsverbindung (5) einbezogen wird.

## Claims

1. An electrical connection device for a battery comprising:
- an electronic circuit (2) comprising at least one member (6) exhibiting heat losses;
- at least one power track (5) adapted to connect the terminals (4) of at least two electrochemical cells (3);
- at least one thermally conductive link (8) adapted to connect said at least one member (6) exhibiting heat losses and at least one of the terminals (4) of one electrochemical cell (3), the electronic circuit and said at least one power track being arranged on an electronic circuit board, **characterized in that** the device comprises power supply tracks (7) of said at least one member (6) exhibiting heat losses, said power supply tracks (7) being electrically insulated from the power tracks (5) connecting the terminals (4) of the electrochemical cells (3).

2. Device according to claim 1, wherein said at least one member (6) exhibiting heat losses is selected from a resistor, an inductor, a diode, a transistor, a fuse, a restriction in the cross-section of an electrical connection track.

3. Device according to one of the preceding claims, wherein said at least one member (6) exhibiting heat losses is positioned at a distance less than 50 mm from the terminal (4) of an electrochemical cell (3).

4. Device according to one of the preceding claims, wherein the thermally conductive link (8) includes at least a portion of a power connection (5).

5. Device according to claim 4, wherein said at least one member (6) exhibiting heat losses comprises a welded metal sole plate directly welded on said at least one power track (5).

6. A battery comprising a plurality of electrochemical cells (3) and at least one electrical connection device according to one of claims 1 to 5.

7. The battery of claim 6, comprising one member (6) exhibiting heat losses per power track (5) connecting the terminals (4) of two electrochemical cells (3).

8. The battery of claim 6, comprising one member (6) exhibiting heat losses per electrochemical cell (3).

9. The battery of claim 6, comprising a plurality of members (6) exhibiting heat losses per power track (5) connecting the terminals (4) of two electrochemical cells (3).

10. Battery according to one of Claims 6 to 9, further comprising a microcontroller adapted to control the power supply to the members (6) exhibiting heat losses.

11. The battery of claim 10, connected to an external power supply providing charging, wherein the microcontroller controls the power supply to the members (6) exhibiting heat losses through the external power supply.

12. A method of making an electrical connection device for a battery comprising the steps of:
- establishing power connections (5) between the terminals (4) of a least two electrochemical cells (3);
- providing an electronic circuit (2) comprising at least one member (6) exhibiting heat losses;
- establishing a thermally conductive link (8), without an electrical connection being established between said at least one member (6) exhibiting heat losses and at least one of the terminals (4) of one of the electrochemical cells (3);
the electronic circuit and at least one power connection being arranged on an electronic circuit board, **characterized in that** said at least one member (6) exhibiting heat losses is electrically powered by power supply tracks (7), said power supply tracks (7) being electrically insulated from the power tracks (5) connecting the terminals (4) of the electrochemical cells (3).

13. The method of claim 12, wherein the thermally conductive link (8) is established by including at least a portion of a power connection (5).
